# EUROPEAN PATENT APPLICATION

(11) **EP 0 662 708 A1**
(43) Date of publication of application: **12.07.1995**
(21) Application number: 94120976.9
(22) Date of filing: 30.12.1994
(51) Int. Cl.: H01L 21/603

(54) **Thermocompression bonding using an aluminium-gold intermetallic**

(30) Priority: 06.01.1994 US 177973
(71) Applicant: HARRIS CORPORATION, Melbourne, Florida 32919 (US)
(72) Inventor: Temple, Victor K.A., Clifton Park, NY 12065 (US); Watrous, Donald L., Clifton Park, NY 12065 (US); Glascock, Homer G., II, Millis, MA 02054 (US); Webster, Harold, Scotia, NY 12302 (US)
(74) Representative: Fleuchaus, Leo, Dipl.-Ing.

(57) **Abstract**

A method of bonding a metal or metalized foil (10) to an aluminum contact pad (14,16) on a semiconductor chip (12) using thermocompression, and devices manufactured using the method. One side of the foil is first coated with a thin barrier layer of chromium and then coated with a thin layer of gold. When the gold layered foil is thereafter thermocompressed onto the contact pad, substantially all of the gold in contact with the aluminum in the contact pad reacts to form AuAl₂ to thereby bond the foil to the contact pad.

## Description

### BACKGROUND

The present invention relates to methods of packaging semiconductor chips, and more particularly to an improved method of bonding a metal or metalized foil to an aluminum contact pad on a semiconductor chip by thermocompression.

Packages for semiconductor chips are available in diverse sizes and capability, and are designed to meet the peculiar requirements of the chips they contain. The size of the package may be driven in part by these requirements, but, in general, package size is desirably as small as feasible. However, in some packages, especially packages for power semiconductor devices, the need to attach electrical leads to the chips may override other package design considerations and thwart efforts to reduce size. Conventional methods of attaching electrical leads to chips, such as soldering or brazing, are not particularly adaptable to reduced size designs because such methods require space to access the lead and chip, use materials that may spread, or are susceptible to grain boundary corrosion. Further, such methods may increase parasitic impedance of the packaged assembly.

Efforts to reduce package size by changing the way electrical leads are attached to the chip have met with some success. For example, the electrical leads may be foils 1 to 10 mils thick that extend perpendicularly from the surface of the chip so that the footprint of the chip (its top plan view surface area) is not increased by the leads. However, the method by which the foil is bonded to the contact pad on the chip may introduce new problems, such as bonding material pollution of the underlying silicon. See, for example, U.S. Patent 5,105,536 issued April 21, 1992 to Neugebauer, et al. in which beads of bulk gold used to bond the foil and chip may spread beyond the area to be bonded and pollute the silicon.

Further, the foils that are to be bonded to the contact pads are so thin that they are difficult to handle and move into position, especially when the foil is to have a particular shape and may be separated from other foils by only a small distance. As is known, a larger-than-needed foil may be applied to the chip surface, including the contact pads, and thereafter partitioned as appropriate to cover the contact pads. However, the etching step adds cost and time to the manufacturing process, and may, if not carefully accomplished, increase the number of units that are rejected in the manufacturing process.

The problem of attaching an electrical lead to a contact pad in a small space is exacerbated when the contact pad and the lead are of dissimilar materials that are not easily bonded. One of the more pressing problems, and one of the problems to which the present invention is directed, is bonding electrical leads to aluminum contact pads in power semiconductor devices, such as MOS controlled thyristors (MCT), insulated gate bipolar transistors (IGBT) and the like that may carry thousands of volts and hundreds of amperes of current.

The size of the package for a combination of semiconductor devices can be further reduced when the packing density can be increased by piggy-back mounting the devices. Piggy-back mounting may also provide the benefits of reduced parasitics, and reduced inductance and resistance of the packaged devices. Conventional attachment methods for piggy-back chips include epoxies (conducting and non-conducting) and solder. When a power current path is to flow from one of the piggy-back chips to the other, the preferred conventional method relies on solder. However, solder is inappropriate with aluminum that is usually found in the contact pads of power devices, and may not provide adequate thermal conductivity. Further, the contact pad metalizations are typically so thin that uniform current flow may be a problem, especially when the power lead is to come from between two piggy-back chips, such as found in antiparallel diodes.

An object of the present invention to provide a method of bonding a foil lead to a contact pad on a semiconductor chip, and to provide a method of bonding a foil to a contact pad on a semiconductor chip that allows the chips to be mounted in close proximity for high packing density, preferably using thermocompression.

A further object is to provide a method of bonding a foil to a contact pad on a semiconductor chip that reduces parasitic impedance in the packaged assembly of semiconductor chips, and to provide a method of bonding a foil lead to contact pads on two piggy-backed semiconductor chips.

Another object is to provide a method of bonding a metal or metalized foil to an aluminum contact pad on a semiconductor chip in which thermocompression is used to form the compound AuAl₂ so as to bond a gold coated foil to the contact pad, and to a method of reducing contamination of a substrate of a semiconductor chip by thermocompression bonding a gold coated foil to an aluminum contact pad using substantially less gold than aluminum at the bonding interface.

Another object is to provide a method of bonding a metal or metalized foil to an aluminum contact pad in which the foil is first attached to an insulative sheet and thereafter partitioned into appropriate shapes to obviate the need to etch the foil while it its on the chip surface.

The present invention includes a method of bonding an electrically conductive lead to an aluminum contact pad on a semiconductor device comprising the steps of:
(a) coating one surface of the lead with a barrier layer;
(b) adding a layer of gold to the coated lead surface; and
(c) thermocompressing the gold layered lead surface onto the aluminum contact pad so that substantially all of the layered gold in contact pad so that substantially all of the layered gold in contact with the aluminum in the contact pad reacts to form the compound AuAl₂ and bonds the lead to the contact pad.

The invention will now be described, by way of example, with reference to the accompanying drawings in which:
Figure 1 is an exploded pictorial representation of an embodiment of the present invention before the foil is bonded to the contact pads.
Figure 2 is a pictorial representation of an embodiment of the present invention illustrating the foil bonded to the contact pads and the tabs extending vertically therefrom.
Figure 3 is a pictorial representation of an embodiment of the present invention illustrating an insulative sheet on the foil in the area of the bond with the tabs folded back thereover.
Figure 4 is a bottom plan view of an insulative sheet of an embodiment of the present invention to which a foil has been attached and partitioned before bonding the foil to the contact pads.
Figure 5 is a partial top plan view of an embodiment of the present invention illustrating an arrangement of the foils on a wafer with a plurality of chips.
Figure 6 is a partial bottom plan view of an insulative sheet for the wafer illustrated in Figure 5 showing the foils before the foils and insulative sheet are attached to the wafer.
Figures 7A-C illustrate an antiparallel diode formed using the method of the present invention; a side view in elevation in Figure 7A, by a schematic circuit diagram in Figure 7B, and in a top plan view in Figure 7C.
Figures 8A-B illustrate a symmetrical blocking diode formed using the method of the present invention; a side view in elevation in Figure 8A, and by a schematic circuit diagram in Figure 8B.
Figures 9A-B illustrate an a.c. switch formed using the method of the present invention; a side view in elevation in Figure 9A, and by a schematic circuit diagram in Figure 9B.
Figures 10A-B illustrate a combination MCT and control IC formed using the method of the present invention; a side view in elevation in Figure 10A, and by a schematic circuit diagram in Figure 10B.

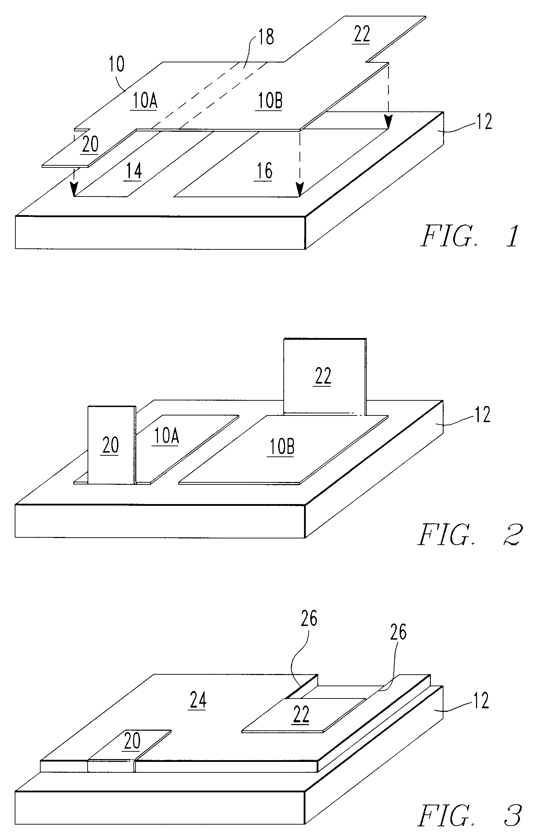

Figure 1 shows an embodiment with an electrical lead 10 attached to a semiconductor chip 12. The chip 12 may have plural aluminum contact pads, such as pads 14 and 16 depicted in Figure 1, for making electrical contact with the chip's gate, cathode, anode, and the like. The lead 10 may be coated on one surface with a thin layer of gold and the coated surface may be thereafter bonded to the aluminum contact pads using thermocompression bonding. The gold layer should be thin so that substantially all of the gold on the lead 10 that contacts the aluminum in the contact pad reacts with the aluminum to form the compound AuAl₂. The compound AuAl₂ is the bonding agent that joins the aluminum and the gold to thereby bond the lead 10 to the contact pads 14 and 16. The surface of the lead 10 with the gold layer may be coated with a thin barrier layer of an appropriate material, such as chromium or titanium, before the gold is applied to the lead 10 so that the gold reacts with the aluminum, and not with the material in the lead 10.

The thermocompression bonding process places the aluminum and the gold under heat and pressure in a suitable atmosphere to create a controlled reaction therebetween. In a preferred embodiment, the aluminum and gold are compressed at about 3000 p.s.i. at or near about 300°C for about one hour in an inert atmosphere, such as nitrogen. Under these conditions, the aluminum and gold react to form AuAl₂, a stable intermetallic compound with a melting point well above that of aluminum. After formation of the AuAl₂ there is no further reaction, producing a stable and reliable bond. The accompanying layer of Kirkendaal voids that may be present (and may be seen when the bond is viewed in microscopic cross section) does not seriously detract from adhesion of the gold and aluminum, which is normally in excess of 12 pounds per inch.

It is desirable that the amount of aluminum exceed that of the gold where the bonding takes place. During the thermocompression process, the gold reacts with the aluminum to form a series of AuAl intermetallics. In a preferred embodiment, the thickness of the gold layer is chosen so that the gold reacts completely to form AuAl₂ (often referred to as the "purple plague"). For conventional aluminum contact pads that are about 50,000 Å thick, the gold layer may be about 8,000 Å to about 20,000 Å thick, to thereby form a layer of AuAl₂. The thickness of the gold layer may vary from this range for thicker or thinner contact pads, but is desirably less than one-half the thickness of the aluminum layer. The reaction of substantially all of the gold with the aluminum leaves a layer of metallic aluminum on the chip and avoids the formation of undesirable gold-rich compounds. The barrier layer may be about 1,500 Å to about 2,500 Å thick.

The lead 10 may be any suitable electrically conductive metal or metalized foil (e.g., mylar) about 1 to 10 mils thick. For example, the metal or metalization may be copper when the chip is small, despite copper's relatively high thermal expansion coefficient, and molybdenum or tungsten may be used when the chip is large and a lead with a thermal expansion coefficient closer to that of silicon is preferred.

After the lead 10 is bonded to the chip 12, the lead 10 may be partitioned to electrically separate the contact pads. For example, as illustrated in Figure 1, the lead 10 may be etched between the dotted lines 18 to separate the lead 10 into sections 10A and 10B.

The lead 10 may also include tabs 20 and 22 that may be electrically connected to external devices as appropriate for the chip 12. With reference to Figure 2, after the lead 10 is bonded in place, the tabs 20 and 22 may be folded to extend away from the chip 12 to provide vertical leads that do not increase the footprint of the chip.

With reference now to Figure 3, an insulative sheet 24 may be placed on top of the chip to cover the bonded portions of the lead 10. Depending on how the tabs 20 and 22 are to be electrically connected, the tabs may be left upright as in Figure 2, or may be folded back onto the insulative sheet 24 to form flat surfaces to which electrical connections may be made. The insulative sheet 24 may be cut and folded with the tab, such as illustrated by cut lines 26 in sheet 24, or the tab may be folded around the edge of the insulative sheet 24, such as illustrated by tab 20.

A thin coat of polyimide or other insulative material may be spun over the chip surface to provide protection, rigidity and improved voltage standoff.

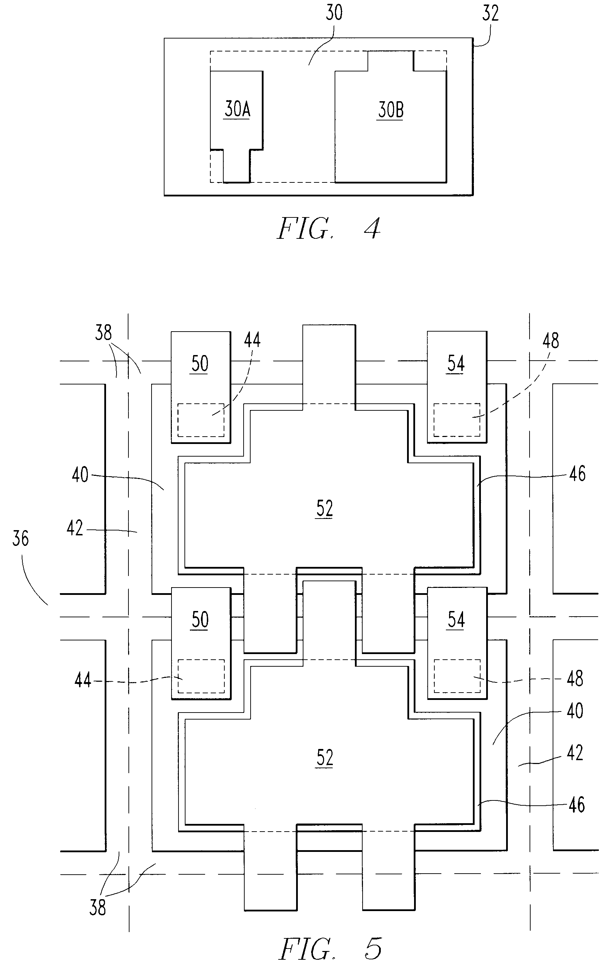

The lead 10 discussed above, while suitable for many applications, may be difficult to move and fit onto the chip because it is so thin. Further, the step of etching the lead 10 after it has been bonded to the chip 12 (such as along the dashed lines 18 in Figure 1) may require precise alignment to avoid etching the underlying silicon. Accordingly, and with reference to Figure 4, in a preferred embodiment of the present invention a foil lead 30 may be attached to an insulative sheet 32 and partitioned into a predetermined pattern before the lead 30 is bonded to the chip. The lead sections 30A and 30B illustrated in Figure 4 remain attached to the sheet 32 after the rest of lead 30 has been removed from the sheet 32. The lead 30 may be thereafter bonded to the chip with its insulative sheet 32 attached, and portions of the insulative sheet 32 may be thereafter left in place to serve as an insulator for the lead 30, removed, or folded, such as illustrated in Figure 3.

In an alternative embodiment, instead of attaching a foil to the insulative sheet, the insulative sheet may be metalized on one surface to form, in effect, a thick foil. In other alternative embodiments, such as the piggy-back devices discussed below, the foil may be attached to two surfaces of the insulative sheet, or two surfaces may be metalized.

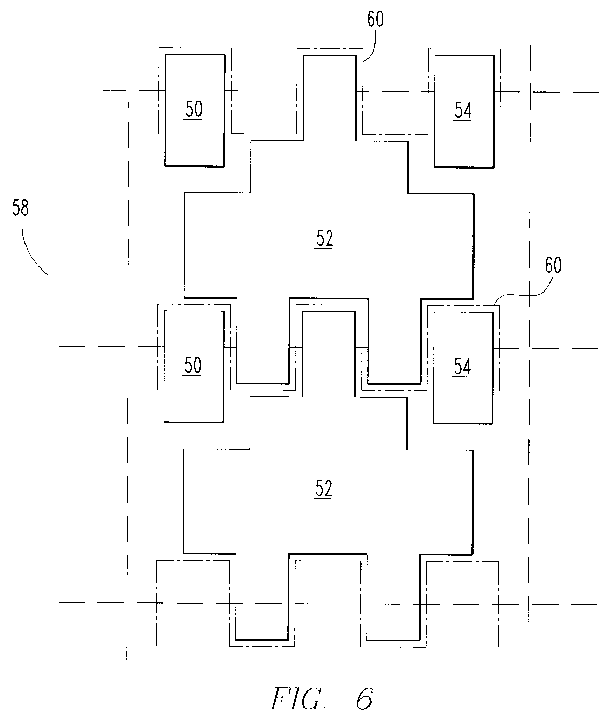

The method illustrated in Figure 4 may be extended to the manufacture of wafers having a multiplicity of chips. For example, and with reference to Figure 5, a wafer 36 may include plural MCT chips 38 (the chips are separated by the long dashed lines in Figure 5 and seen in a top plan view of the chip after the lead has been bonded thereto). Each chip 38 may have an active area 40 that is separated from the edge of the chip by a termination region 42. The chips 38 illustrated in Figure 5 include three passivation windows where the chip's aluminum metalization is exposed and where the bonding is to take place, although the present invention is not so limited. The passivation windows include a pilot device contact 44, a main device contact 46 and a gate contact 48. The lead may include three sections corresponding to the three passivation windows: a pilot foil 50, a main foil 52, and gate foil 54. The three foil sections may be bonded to the passivation windows using the thermocompression bonding method described above, although other bonding methods may be used. The three foil sections 50, 52 and 54 may include tabs that may later be folded in the manner illustrated in Figure 2 before the chips 38 are separated from one another.

With reference now to Figure 6 (a bottom plan view of an insulative sheet and foil for the embodiment of Figure 5), the lead may be attached to an insulative sheet 58 before the lead is bonded to the contacts on the chips. The sheet 58 (shown with long dashed lines corresponding to the chips 38 of Figure 5) may be overlain with a lead foil that may be separated to form the three foil sections 50, 52 and 54. The sheet 58 may be provided with slots 60 (illustrated by the intermittent dashed lines) that correspond to the tabs so that the sheet 58 can folded with the tabs before the chips are separated. The slots 60 may be scribed, cut, etched, or otherwise formed as known in the art. The sheet 58 may be placed onto the wafer 36 so that the foils are appropriately aligned and thereafter bonded.

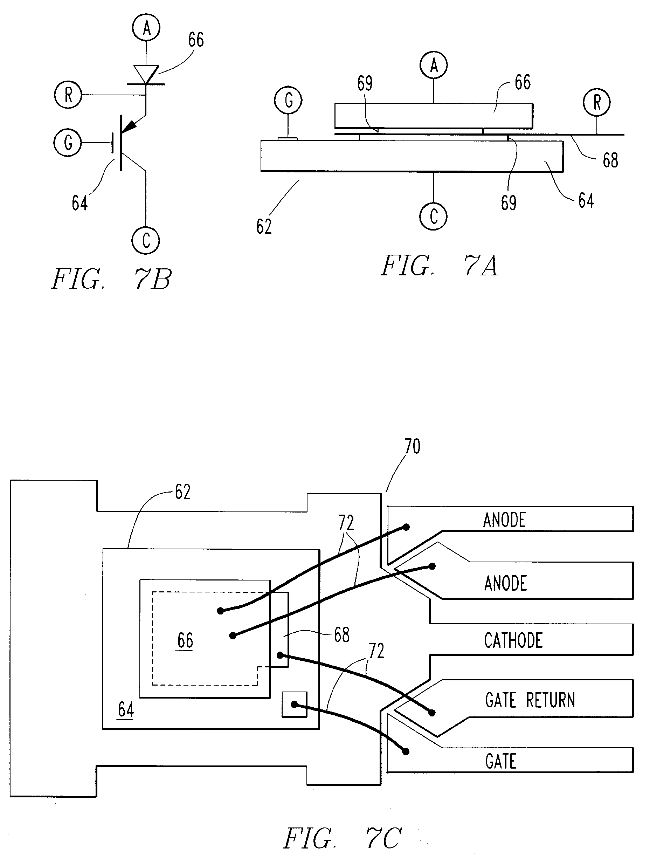

The bonding method of the present invention will also find application in piggy-back mounted chips. By way of example, and with reference to Figures 7A and 7B, two chips may be piggy-back mounted to form an antiparallel diode 62. A power device 64, such as an MCT, IGBT, etc., may be connected to a diode 66 as illustrated by the side view in elevation in Figure 7A and by the schematic circuit diagram in Figure 7B. A foil 68 may be placed between two chips and bonded to the contact pads 69 on the chips using the thermocompression bonding method discussed above (the contact pads 69 of the power device 64 and diode 66 are facing each other in the embodiment of Figure 7). The antiparallel diode 62 may have gate contact G, anode contact A, cathode contact C, and gate return R, as appropriate.

A top plan view of an embodiment of an antiparallel diode such as illustrated in Figure 7A-B may be seen in Figure 7C in which similar elements have been given the same identifying numbers as in Figures 7A-B. The antiparallel diode 62 with diode 66 and power device 64 separated by a foil lead 68 may be mounted on a 5-pin base 70 that is connected to the cathode of the antiparallel diode 62. Additional contacts for the anode and gate and gate return may also be provided, with appropriate electrical connections 72 being made. The relative sizes of the components illustrated is exemplary only, as the present invention is not so limited.

The bonding sequence of the piggy-back chips may have several embodiments. For example, the foil 68 may be thermocompression bonded to the device 64, and thereafter the device 64 may be soldered to the base 70 and to the diode 66. Alternatively, the device 64 and diode 66 may be thermocompression bonded to the foil 68 in one operation, and the piggy-backed pair thereafter soldered to the base 70. Further, the device 64, diode 66, foil 68 and base 70 all may be thermocompression bonded, provided the base has been suitably provided with a gold layer as described above and the device 64 has been provided with an aluminum underside.

When used with piggy-back chips, the present invention provides improved thermal conductivity (for example, a 10 mil foil lead can halve the thermal resistance for a thermal pulse of up to about 10 milliseconds), and increases lateral conduction over that found in conventionally attached devices.

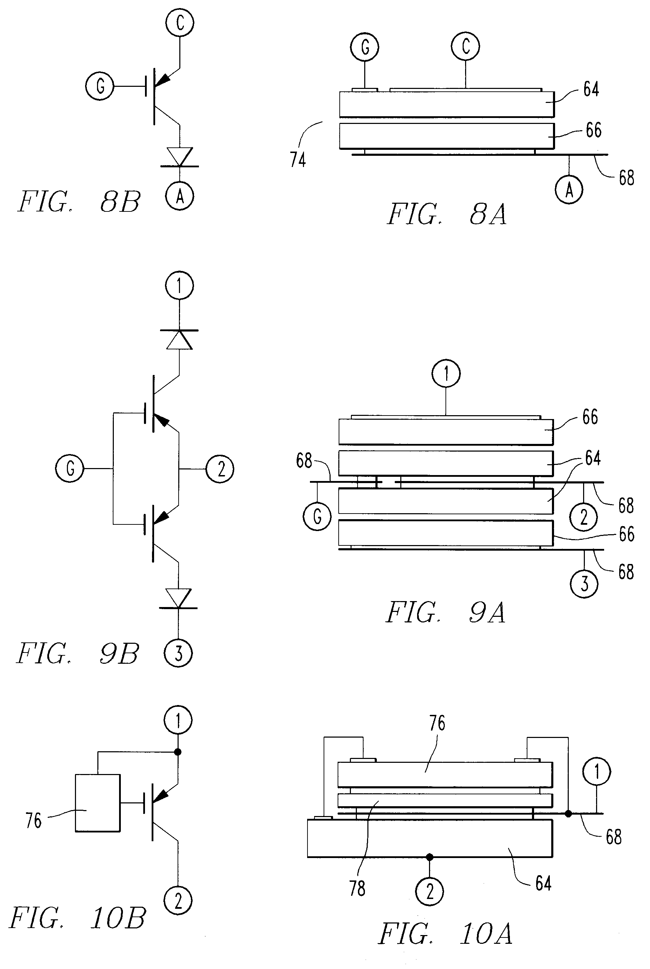

With reference now to Figures 8-10 in which similar elements have been given the same identifying numbers as in Figures 7A-C, the method of the present invention will find application in various other combinations of semiconductor devices. For example, as seen in Figure 8A-B a symmetrical blocking diode 74 may be formed by moving the diode 66 from a face-to-face to a back-to-back relationship with the power device 64. An exemplary a.c. switch is illustrated in Figures 9A-B, and a combination MCT and integrated circuit 76 for controlling the MCT may be seen in Figures 10A-B. The latter example uses an insulative sheet 78 that may be foil covered or metalized in the manner discussed above.

## Claims

1. A method of bonding an electrically conductive lead to an aluminum contact pad on a semiconductor device comprising the steps of:
(a) coating one surface of the lead with a barrier layer;
(b) adding a layer of gold to the coated lead surface; and
(c) thermocompressing the gold layered lead surface onto the aluminum contact pad so that substantially all of the layered gold in contact with the aluminum in the contact pad reacts to form the compound AuAl₂ and bonds the lead to the contact pad.

2. A method as claimed in claim 1 wherein the lead is a foil comprised of a metal selected from the group of metals consisting of copper, tungsten and molybedenum.

3. A method as claimed in claim 1 or 2 wherein the barrier layer comprises chromium or titanium and is about 1,500 Å to about 2,500 Å thick.

4. A method as claimed in claim 1, 2 or 3 wherein the layer of gold is about 8,000 Å to about 20,000 Å thick.

5. A method as claimed in claim 4 wherein the layer of gold is no greater than about one-half as thick as the aluminum contact pad.

6. A method as claimed in any one of claims 1 to 5 wherein the thermocompression is at a temperature of about 300° C for about one hour in an inert atmosphere.

7. A method as claimed in claim 6 wherein the thermocompression is to about 3000 p.s.i., with the lead of about 1 mil to about 10 mils thick, and further comprising the step of partitioning the lead to form a predetermined pattern after it has been thermocompressed to the contact pad.

8. A method as claimed in claims 1 to 2 characterized by the steps between steps (b) and (c), of (d) applying the gold layered lead to an insulative sheet, and (e) partitioning the lead to from a predetermined pattern after it has been applied to the insulative sheet, and further comprising the additional steps of:
(d) coating a second surface of the lead with a barrier layer;
(e) adding a layer of gold to the coated lead second surface; and
(f) thermocompressing the gold layered lead second surface to an aluminum contact pad of a second semiconductor device to thereby electrically connect the contact pads of the two semiconductor devices.

9. A method of attaching a power lead to an aluminum contact pad on a semiconductor chip within a footprint of the chip, comprising the steps of:
(a) coating a surface of the power lead with a layer of gold;
(b) thermocompressing a portion of the gold layered lead surface onto the aluminum contact pad so that substantially all of the layered gold in contact with the aluminum in contact pad forms AuAl₂ and thereby bonds the thermocompressed portion of the lead to the contact pad; and
(c) bending unbonded portions of the lead away from the chip sufficiently to locate the leads within the footprint of the chip.

10. A method as claimed in claim 9 including the additional steps of (d) attaching an inuslative sheet to the uncoated surface of the lead, and (e) folding the bent unbonded portions of the lead back over the insulative sheet to overlie the bonded portion to thereby provide an upwardly facing lead contact area, and further comprising the step of attaching the upwardly facing lead contact area to an aluminum contact pad of a second semiconductor device to electrically connect the contact pads of the two semiconductor devices.

11. A method of bonding a lead to an aluminum contact pad of a semiconductor chip comprising the steps of:
(a) coating a surface of the lead with a layer of gold;
(b) attaching an uncoated surface of the lead to an insulative sheet;
(c) partitioning the lead to form a preselected pattern;
(d) thermocompressing a portion of the gold coated lead surface onto the aluminum contact pad so that substantially all of the layered gold in contact with the aluminum in the contact pad forms AuAl₂ to hereby bond the lead to the contact pad; and
(e) folding an unbonded portion of the lead to overlie the bonded portion with the insulative sheet therebetween.

12. A method of electrically connecting the aluminum contact pads of two semiconductor chips comprising the steps of:
(a) coating a surface of a lead with a barrier layer;
(b) adding a layer of gold to the coated surface of the lead;
(c) positioning the lead between the chips so that the lead overlies the contact pads on the two chips that are to be electrically connected; and
(d) thermocompressing the lead onto the contact pads of the two chips so that substantially all of the gold in contact with the aluminum in the contact pads reacts to form AuAl₂ to thereby bond the lead to the contact pads of the two chips and to electrically connect the two chips by means of the lead.
